# EUROPÄISCHE PATENTSCHRIFT

(11) **EP 3 464 688 B1**
(45) Veröffentlichungstag und Bekanntmachung des Hinweises auf die Patenterteilung: **17.06.2020**
(21) Anmeldenummer: 17724025.6
(22) Anmeldetag: 17.05.2017
(51) Int. Cl.: C30B 15/04, C30B 15/14, C30B 15/20, C30B 15/30, C30B 29/06

(54) **VERFAHREN ZUR HERSTELLUNG EINER HALBLEITERSCHEIBE AUS EINKRISTALLINEM SILIZIUM UND VORRICHTUNG ZUR HERSTELLUNG EINER HALBLEITERSCHEIBE AUS EINKRISTALLINEM SILIZIUM**
METHOD FOR PRODUCING A SEMICONDUCTOR WAFER OF MONOCRYSTALLINE SILICON AND DEVICE FOR PRODUCING A SEMICONDUCTOR WAFER OF MONOCRYSTALLINE SILICON
PROCÉDÉ DE PRODUCTION D'UNE PLAQUETTE DE SEMI-CONDUCTEUR EN SILICIUM MONOCRISTALLIN ET DISPOSITIF DE PRODUCTION D'UNE PLAQUETTE DE SEMI-CONDUCTEUR EN SILICIUM MONOCRISTALLIN

(30) Priorität: 24.05.2016 DE 102016209008
(43) Veröffentlichungstag der Anmeldung: 10.04.2019
(73) Patentinhaber: Siltronic AG, 81737 München (DE)
(72) Erfinder: HEUWIESER, Walter, 84533 Stammham (DE); KNERER, Dieter, 84533 Haiming (DE); SCHACHINGER, Werner, 84359 Simbach (DE); OOKUBO, Masamichi, Hikari City Yamaguchi 743-0000 (JP)
(74) Vertreter: Staudacher, Wolfgang
(86) Internationale Anmeldenummer: PCT/EP2017/061784
(87) Internationale Veröffentlichungsnummer: WO 2017/202656

(56) Entgegenhaltungen:
- WO-A2-2014/190165
- DE-T5-112012 000 306
- JP-A- H05 294 782
- US-A- 6 007 625
- US-A1- 2007 215 038
- US-A1- 2011 214 604

## Beschreibung

Gegenstand der Erfindung ist ein Verfahren zur Herstellung einer Halbleiterscheibe aus einkristallinem Silizium, die Sauerstoff und mindestens einen Dotierstoff vom n-Typ enthält, wobei die Sauerstoff-Konzentration und die radiale Variation der Sauerstoff-Konzentration vergleichsweise gering sind. Gegenstand der Erfindung ist auch eine Vorrichtung, die zur Herstellung der Halbleiterscheibe geeignet ist.

### Stand der Technik / Probleme

Eine Halbleiterscheibe aus einkristallinem Silizium mit den oben genannten Eigenschaften stellt ein Substrat dar, das insbesondere verwendet wird, um elektronische Bauelemente auf der Basis von bipolaren Transistoren mit isoliertem Gate, IGBTs, herzustellen. Die Sauerstoff-Konzentration des Substrats muss möglichst niedrig sein, weil im Zuge der Herstellung von elektronischen Bauelementen thermische Donatoren unter Mitwirkung des Sauerstoffs gebildet werden, die den elektrischen Widerstand zum Nachteil der Funktionstüchtigkeit der Bauelemente verändern können. Das Erfordernis, dass die Sauerstoff-Konzentration des Substrats vergleichsweise gering sein muss, stellt eine Herausforderung dar, insbesondere, wenn gleichzeitig erwartet wird, dass der Durchmesser der Halbleiterscheibe mindestens 300 mm betragen soll.

Unter solchen Umständen muss der Einkristall, von dem die Halbleiterscheibe abgetrennt wird, gemäß der CZ-Methode gezüchtet werden. Das Züchten eines Einkristalls aus Silizium gemäß der CZ-Methode umfasst das Schmelzen von polykristallinem Silizium in einem Quarz-Tiegel, das Eintauchen eines Keimkristalls in die entstandene Schmelze und das Ziehen des Keimkristalls nach oben, wobei an der Unterseite des Keimkristalls Material zu kristallisieren beginnt, während der Quarz-Tiegel und der Keimkristall gedreht werden. Ein Teil dieses Materials wird zu einem Einkristall aus Silizium, von dem in der Regel einkristalline Halbleiterscheiben aus Silizium abgetrennt werden.

Die Schmelze aus Silizium löst Sauerstoff aus dem Tiegelmaterial, der teilweise in den wachsenden Einkristall eingebaut wird und teilweise aus der Schmelze in Form von gasförmigen SiO entweicht. Es sind besondere Maßnahmen notwendig, um zu erreichen, dass die Sauerstoff-Konzentration im Einkristall ausreichend niedrig bleibt, damit sich das einkristalline Material zur Herstellung von IGBTs eignet.

Andererseits stärkt die Anwesenheit von Sauerstoff im Kristallgitter die Widerstandsfähigkeit der Halbleiterscheibe aus einkristallinem Silizium gegen Vergleitungen (slip) durch thermisch oder mechanisch hervorgerufene Spannungen. Ist die Sauerstoff-Konzentration im Einkristall vergleichsweise niedrig, besteht das Problem, dass Halbleiterscheiben aus einkristallinem Silizium, die von einem solchen Einkristall abgetrennt werden, einen Abfall der Sauerstoff-Konzentration im Randbereich aufweisen und der Randbereich besonders anfällig für das Entstehen von Vergleitungen ist.

In WO 2014/190 165 A2 ist ein Verfahren zur Herstellung eines Einkristalls aus Silizium mit vergleichsweise niedriger Sauerstoff-Konzentration beschrieben.

US 6 007 625 A offenbart eine Vorrichtung zur Herstellung von Einkristallen aus Silizium mit vergleichsweise niedriger Sauerstoff-Konzentration, die eine Heizeinrichtung umfasst, die auf die Oberfläche der Schmelze einwirkt.

US 2007/215 038 A1 betrifft eine Vorrichtung zur Herstellung von Einkristallen aus Halbleitermaterial umfassend mehrere Heizeinrichtungen, die zur Herstellung von Einkristallen mit vergleichsweise niedriger Sauerstoff-Konzentration und von Einkristallen mit vergleichsweise hoher Sauerstoff-Konzentration geeignet ist.

Bei Dotierung der Schmelze mit Dotierstoff vom n-Typ, beispielsweise mit Phosphor, reichert sich der Dotierstoff mit zunehmender Kristallisation des Einkristalls in der Schmelze an. Wegen dieses Segregationseffekts sinkt der spezifische Widerstand im Einkristall in Richtung zum unteren Ende des Einkristalls hin. Halbleiterscheiben, die vom Einkristall abgetrennt werden und als Substrate zur Herstellung von IGBTs in geeignet sollen, dürfen sich bezüglich ihrer elektrischen Eigenschaften kaum unterscheiden. Um entgegenzuwirken, dass der spezifische Widerstand über die Länge des Einkristalls abnimmt, kann der Schmelze Dotierstoff vom p-Typ, beispielsweise Bor, hinzugefügt werden, um die segregationsbedingte Zunahme an Ladungsträgern zu kompensieren. Diese Maßnahme wird Gegendotieren genannt und beispielsweise in US2015/0 349 066 A1 ausführlich beschrieben.

US2007/0 193 501 A1 beschreibt die Herstellung einer Halbleiterscheibe aus einkristallinem Silizium mit einer Sauerstoff-Konzentration von nicht mehr als 4,33 x 10¹⁷ Atome/cm³, wobei der angegebene Wert auf new ASTM umgerechnet wurde. In dem Dokument enthaltene Beispiele zeigen, dass Halbleiterscheiben mit einer Konzentration von umgerechnet 2,6 x 10¹⁷ Atome/cm³ tatsächlich hergestellt wurden. Das im Dokument beschriebene Herstellungsverfahren umfasst die Züchtung eines Einkristalls aus Silizium gemäß der CZ-Methode, wobei zur Steigerung der Ausbeute gegendotiert wird.

EP 0 926 270 A1 offenbart eine ringförmige Heizvorrichtung, deren Verwendung das Entweichen von SiO über die Oberfläche der Schmelze begünstigt.

Aufgabe der vorliegenden Erfindung ist es aufzuzeigen, wie n-Typ dotierte Halbleiterscheiben aus einkristallinem Silizium mit noch niedrigeren SauerstoffKonzentrationen zur Verfügung gestellt werden können, insbesondere solche, bei denen die radiale Variation der Sauerstoff-Konzentration reduziert ist, und wie die Ausbeute an solchen Halbleiterscheiben optimiert werden kann.

Die Aufgabe der Erfindung wird gelöst durch ein Verfahren zur Herstellung einer Halbleiterscheibe aus einkristallinem Silizium, die Sauerstoff und mindestens einen Dotierstoff vom n-Typ enthält, umfassend
das Bereitstellen einer Schmelze aus Silizium, die Dotierstoff vom n-Typ enthält, in einem Quarz-Tiegel, wobei eine Oberfläche der Schmelze eine anfängliche Höhe hM hat;
das Erhitzen der Schmelze von der Seite durch selektives Zuführen von Wärme zu einem oberen Volumen der Schmelze, das eine anfängliche Höhe hm hat, wobei die Höhe hm kleiner ist als die Höhe hM;
das Ziehen eines Einkristalls aus Silizium gemäß der CZ-Methode aus der Schmelze mit einer Ziehgeschwindigkeit V;
das Erhitzen der Schmelze von oben im Bereich einer Phasengrenze zwischen dem wachsenden Einkristall und der Schmelze;
das Erhitzen der Schmelze von oben im Bereich der Oberfläche der Schmelze zwischen einem Hitzeschild und einer Wand des Quarz-Tiegels;
das Beaufschlagen der Schmelze mit einem Magnetfeld;
das Gegendotieren der Schmelze mit Dotierstoff vom p-Typ; und das Abtrennen der Halbleiterscheibe aus einkristallinem Silizium vom Einkristall.

Das Verfahren macht eine Halbleiterscheibe aus einkristallinem Silizium zugänglich, die Sauerstoff, thermische Donatoren und mindestens einen Dotierstoff vom n-Typ enthält und einen Durchmesser von nicht weniger als 300 mm hat. Die Sauerstoff-Konzentration der Halbleiterscheibe ist kleiner als 2,2 x 10¹⁷ Atome/cm³, vorzugsweise kleiner als 2,0 x 10¹⁷ Atome/cm³, und weicht in radialer Richtung von einem Mittelwert um nicht mehr als 5 % ab. Die Dichte an thermischen Donatoren in der Halbleiterscheibe ist nicht mehr als 3 x 10¹³/cm³.

Vorzugsweise beträgt die Abweichung der Sauerstoff-Konzentration von einem Mittelwert in einem Randbereich umfassend die radialen Positionen von 130 mm bis 150 mm nicht mehr als 10 %.

Die Erfinder haben festgestellt, dass eine Reihe von Maßnahmen getroffen werden müssen, um die Aufgabe zu lösen. Es werden Strömungsverhältnisse und ein Temperaturfeld in der Schmelze erzeugt, die das Lösen von Sauerstoff aus dem Tiegelmaterial behindern und das Entweichen von SiO aus der Schmelze über die Oberfläche der Schmelze fördern, und die begünstigen, dass Sauerstoff im wachsenden Einkristall vom Zentrum bis zum Rand des Einkristalls homogen verteilt aufgenommen wird. Darüber hinaus werden beim Ziehen des Einkristalls die Ziehgeschwindigkeit und die Abkühlrate des Einkristalls kontrolliert, um die Konzentration an thermischen Donatoren im Einkristall gering zu halten.

Die Schmelze aus Silizium, die Dotierstoff vom n-Typ enthält, wird vorzugsweise bereitgestellt, indem polykristallines Silizium und Dotierstoff vom n-Typ, beispielsweise Phosphor, in einem Quarz-Tiegel geschmolzen werden.

Während des Ziehens eines Einkristalls wird der Schmelze von mindestens drei Stellen Wärme zugeführt. Von oben im Bereich der Phasengrenze zwischen dem wachsenden Einkristall und der Schmelze, von oben im Bereich der Oberfläche der Schmelze und selektiv von der Seite zur oberen Hälfte der Schmelze. Darüber hinaus kann die Schmelze zusätzlich auch von unten erhitzt werden, beispielsweise um unter Beibehaltung der Gesamtheizleistung für eine Entlastung der Heizleistung an mindestens einer der mindestens drei Stellen zu sorgen. Beispielsweise kann es vorteilhaft sein, die Wärmezufuhr von der Seite zu verringern, um den Quarz-Tiegel zu schonen und um entgegenzuwirken, dass der obere Teil der Tiegelwand seine Form verliert und zur Schmelze kippt.

Die Wärmezufuhr zur Schmelze erfolgt vorzugsweise derart, dass das Verhältnis von der Heizleistung zur Gesamtheizleistung im Fall des Erhitzens der Schmelze von oben im Bereich der Phasengrenze nicht weniger als 5 % und nicht mehr als 15 % beträgt und im Fall des Erhitzens der Schmelze von oben im Bereich der Oberfläche nicht weniger als 5 % und nicht mehr als 15 % beträgt. Falls die Schmelze zusätzlich von unten erhitzt wird beträgt das Verhältnis der dafür aufgewendeten Heizleistung zur Heizleistung, die aufgewendet wird, um die Schmelze von der Seite zu erhitzen vorzugsweise nicht mehr als 5 %.

Die Wärmezufuhr von der Seite muss selektiv zu einem oberen Anteil des Volumens der Schmelze gerichtet sein. Mit anderen Worten, ein beabsichtigtes Erhitzen von der Seite eines unteren Anteils des Volumens der Schmelze findet am Anfang der Kristallzucht nicht statt und vorzugsweise solange nicht, bis 70 % des anfänglichen Volumens der Schmelze Bestandteil des Einkristalls geworden sind. Andernfalls können die gewünschten Strömungsverhältnisse und das gewünschte Temperaturfeld in der Schmelze nicht erzeugt werden. Dementsprechend umfasst das Verfahren das selektive Zuführen von Wärme zu einem oberen Volumen der Schmelze, das eine anfängliche Höhe hm hat, wobei die Höhe hm kleiner ist als die anfängliche Höhe hM der Schmelze. Das Verhältnis hm : hM beträgt vorzugsweise nicht mehr als 0,75. Das durch das Kristallisieren des Einkristalls verursachte Absinken der Schmelze wird durch ein Anheben des Quarz-Tiegels ausgeglichen.

Weiterhin findet ein Erhitzen der Schmelze von oben statt und zwar sowohl im Bereich der Phasengrenze zwischen dem wachsenden Einkristall und der Schmelze als auch im Bereich der Oberfläche der Schmelze, genauer im Bereich der Oberfläche der Schmelze zwischen einem Hitzeschild, der den wachsenden Einkristall umgibt, und der Wand des Quarz-Tiegels. Beides geschieht mittels zweier Heizeinrichtungen nahezu unbeeinflusst voneinander, weil der Hitzeschild das zusätzliche Erhitzen des jeweils anderen Bereichs durch eine der zwei Heizeinrichtungen blockiert.

Das Erhitzen der Schmelze von oben im Bereich der Phasengrenze zwischen dem wachsenden Einkristall und der Schmelze dient insbesondere der Regelung des axialen Temperaturgradienten G an der Phasengrenze zwischen dem wachsenden Einkristall und der Schmelze. Es ist bekannt, dass die Bildung von Eigenpunktdefekten (Silizium-Zwischengitteratome und Leerstellen) und deren Agglomeraten maßgeblich vom Quotienten V/G der Ziehgeschwindigkeit V und dem axialen Temperaturgradienten G abhängt. Der axiale Temperaturgradient G kann mittels Simulationsrechnungen näherungsweise berechnet und durch die Konstruktion der näheren Umgebung des wachsenden Einkristalls, der hot zone, wesentlich beeinflusst werden. Der Einkristall aus Silizium wird mit einer Ziehgeschwindigkeit V gemäß der CZ-Methode gezogen, vorzugsweise mit einer Ziehgeschwindigkeit V, die ein V/G nach sich zieht, das zur Folge hat, dass im wachsenden Einkristall Silizium-Zwischengitteratome keine Agglomerate bilden und dass die Konzentration an freien Leerstellen, deren Präsenz das Entstehen von thermischen Donatoren begünstigt, möglichst gering ist, vorzugsweise nicht mehr als 3 x 10¹⁴ /cm³. Dementsprechend ist es besonders bevorzugt, den Quotienten V/G derart zu regeln, dass vom Zentrum bis zum Rand des Einkristalls Leerstellen dominieren, ohne Agglomerate zu bilden, die als COP-Defekte (crystal originated particles) nachweisbar sind und/oder dass vom Zentrum bis zum Rand des Einkristalls Silizium-Zwischengitteratome dominieren, ohne Agglomerate zu bilden, die als Lpit-Defekte (large etch pits) nachweisbar sind.

Das Erhitzen der Schmelze von oben im Bereich einer Oberfläche der Schmelze trägt dazu bei, die Strömungsverhältnisse und das Temperaturfeld in der Schmelze zu erzeugen, die nötig sind, um die Sauerstoff-Konzentration im Einkristall aus Silizium auf weniger als 2,2 x 10¹⁷ Atome/cm³ zu begrenzen.

Darüber hinaus wird ein Magnetfeld an die Schmelze gelegt, vorzugsweise ein CUSP-Feld, also ein Magnetfeld mit einer Struktur der Feldlinien, die axialsymmetrisch zur Drehachse des Quarz-Tiegels ist. Das Magnetfeld hat vorzugsweise eine maximale Flussdichte von 700 - 1300 Gauß. Die Ebene des Magnetfelds mit der geringsten magnetischen Flussdichte liegt vorzugsweise mit einem Abstand von 80 mm bis 160 mm über der Oberfläche der Schmelze oder mit einem Abstand von 120 mm bis 220 mm unter der Oberfläche der Schmelze.

Um die Entstehung thermischer Donatoren zusätzlich einzudämmen, umfasst das Verfahren vorzugsweise das Abkühlen des wachsenden Einkristalls aus Silizium im Temperaturbereich von 500 °C bis 400 °C mit einer Abkühlrate von nicht weniger als 0,15 °C/min und nicht mehr als 0,6 °C/min, vorzugsweise nicht mehr als 0,25 °C/min. Es wurde festgestellt, dass die Konzentration an thermischen Donatoren mit steigender Abkühlrate abnimmt. Allerdings sollte eine Abkühlrate von größer als 0,6 °C/min nicht angestrebt werden, weil das zu Lasten der Homogenität der Konzentration an Leerstellen in radialer Richtung geht. Dementsprechend sollte berücksichtigt werden, dass die Abkühlrate mit zunehmender Ziehgeschwindigkeit üblicherweise größer wird.

Um die Variation des spezifischen elektrischen Widerstands im Abschnitt des Einkristalls einzudämmen, der zu Halbleiterscheiben aus einkristallinem Silizium weiterverarbeitet wird, wird die Schmelze mit Dotierstoff vom p-Typ gegendotiert, vorzugsweise indem ein Gas, das den Dotierstoff vom p-Typ enthält, beispielsweise eine Mischung von Diboran und Argon, zur Oberfläche der Schmelze geleitet wird. Dieses Gas wird dann in einem Abstand von vorzugsweise 5 mm bis 50 mm zur Oberfläche der Schmelze in die Atmosphäre über der Schmelze eingeleitet.

Zur Steigerung der Ausbeute an Halbleiterscheiben aus einkristallinem Silizium ist es vorteilhaft und daher bevorzugt, mit dem Gegendotieren erst zu beginnen, nachdem mindestens 20 %, besonders bevorzugt mindestens 30 % des Abschnitts des Einkristalls kristallisiert sind, der wegen seines einheitlichen Durchmessers zur Herstellung von Halbleiterscheiben geeignet ist. Solange mit dem Gegendotieren noch nicht begonnen wurde, kann im Fall einer Versetzungsbildung im Einkristall das bis zu diesem Ereignis kristallisierte Material zurückgeschmolzen und das zurückgeschmolzene Material für einen neuen Züchtungsversuch mitverwendet werden, weil die dann resultierende Schmelze die gleiche Zusammensetzung hat, wie die ursprünglich eingesetzte Schmelze am Anfang der Kristallzüchtung. Enthält das zurückgeschmolzene Material bereits Dotierstoff beider Typen, ist das nicht mehr der Fall. Die relative Häufigkeit des Ereignisses der Versetzungsbildung ist am Anfang der Kristallzüchtung am größten, weshalb es vorteilhaft ist, mit dem Gegendotieren möglichst lange zu warten.

Gegenstand der Erfindung ist auch eine Vorrichtung zur Herstellung einer Halbleiterscheibe aus einkristallinem Silizium gemäß der CZ-Methode, umfassend einen Quarz-Tiegel;
eine Schmelze aus Silizium im Quarz-Tiegel mit einer Oberfläche, die eine anfängliche Höhe hM hat;
eine Einrichtung zum Beaufschlagen der Schmelze mit einem Magnetfeld;
einen Hitzeschild zum Abschirmen eines wachsenden Einkristalls aus Silizium;
eine erste Heizeinrichtung zum Erhitzen der Schmelze von der Seite mit einer unteren Begrenzung, die tiefer angeordnet ist, als die Oberfläche der Schmelze mit anfänglicher Höhe hM, wobei der Abstand hs der unteren Begrenzung zur Oberfläche der Schmelze mit anfänglicher Höhe hM kleiner ist, als die anfängliche Höhe hM; eine zweite Heizeinrichtung zum Erhitzen der Schmelze von oben im Bereich einer Phasengrenze zwischen dem wachsenden Einkristall und der Schmelze; und
eine dritte Heizeinrichtung zum Erhitzen der Schmelze von oben, die um den Hitzeschild herum zwischen einer Wand des Tiegels und dem Hitzeschild angeordnet ist.

Die Einrichtung zum Beaufschlagen der Schmelze mit einem Magnetfeld ist vorzugsweise eine Einrichtung zum Beaufschlagen der Schmelze mit einem Magnetfeld vom CUSP-Typ.

Die Höhe hM bezeichnet die größte anfängliche Höhe der Oberfläche der Schmelze. Hat der Quarz-Tiegel einen Boden, der konvex nach unten gewölbt ist, bezeichnet die anfängliche Höhe hM die anfängliche Höhe der Oberfläche der Schmelze in der Mitte des Quarz-Tiegels.

Die erste Heizeinrichtung zum Erhitzen der Schmelze von der Seite ist vorzugsweise eine Widerstandsheizung und hat eine untere Begrenzung. Der anfängliche Abstand hs zwischen der unteren Begrenzung der ersten Heizeinrichtung und der Oberfläche der Schmelze hat annähernd die Länge der anfänglichen Höhe hm des oberen Volumens der Schmelze und ist kleiner, als die anfängliche Höhe hM. Das Verhältnis hs : hM beträgt vorzugsweise nicht mehr als 0,75.

Die zweite und dritte Heizeinrichtung zum Erhitzen der Schmelze von oben umfassen vorzugsweise Widerstandsheizungen mit Heizelementen, die zu Ringen geformt sind. Im Fall der dritten Heizeinrichtung hat der Ring im Querschnitt ein Aspekt-Verhältnis (Höhe zu Breite) von vorzugsweise nicht mehr als 0,35, um einen möglichst hohen Anteil an Wärme zur Oberfläche der Schmelze abgeben zu können. Der Abstand, den der Ring der dritten Heizeinrichtung zur Wand des Quarz-Tiegels hat und sein Abstand zum Hitzeschild betragen jeweils vorzugsweise nicht weniger als 10 mm. Die dritte Heizeinrichtung kann nach oben hin thermisch isoliert sein, vorzugsweise durch eine wärmedämmende Abdeckung, die darüber angeordnet ist.

Vorzugsweise ist ein Glasrohr Bestandteil der erfindungsgemäßen Vorrichtung, das zur Oberfläche der Schmelze gerichtet ist und dessen unteres Ende einen Abstand von 5 mm bis 50 mm zur Oberfläche der Schmelze hat. Dotierstoff vom p-Typ enthaltendes Gas wird beim Gegendotieren durch das Glasrohr geleitet.

Darüber hinaus kann die erfindungsgemäße Vorrichtung eine Kühlvorrichtung aufweisen, die den wachsenden Einkristall umgibt.

Die bezüglich der vorstehend aufgeführten Ausführungsformen des erfindungsgemäßen Verfahrens angegebenen Merkmale können entsprechend auf die erfindungsgemäße Vorrichtung übertragen werden. Umgekehrt können die bezüglich der vorstehend ausgeführten Ausführungsformen der erfindungsgemäßen Vorrichtung angegebenen Merkmale entsprechend auf das erfindungsgemäße Verfahren übertragen werden. Diese und andere Merkmale der erfindungsgemäßen Ausführungsformen werden in der Figurenbeschreibung und in den Ansprüchen erläutert. Die einzelnen Merkmale können entweder separat oder in Kombination als Ausführungsformen der Erfindung verwirklicht werden. Weiterhin können sie vorteilhafte Ausführungen beschreiben, die selbstständig schutzfähig sind.

Die Erfindung wird nachfolgend unter Bezugnahme auf Zeichnungen weiter erläutert.
**Fig. 1** zeigt schematisch eine Vorrichtung zur Herstellung einer Halbleiterscheibe aus einkristallinem Silizium gemäß der CZ-Methode mit Merkmalen der Erfindung vor dem Ziehen eines Einkristalls.
**Fig. 2** zeigt die Vorrichtung gemäß Fig.1 während des Ziehens eines Einkristalls.
**Fig. 3** zeigt eine mögliche Ausgestaltung der Heizeinrichtung zum Erhitzen der Schmelze von oben im Bereich der Oberfläche der Schmelze.

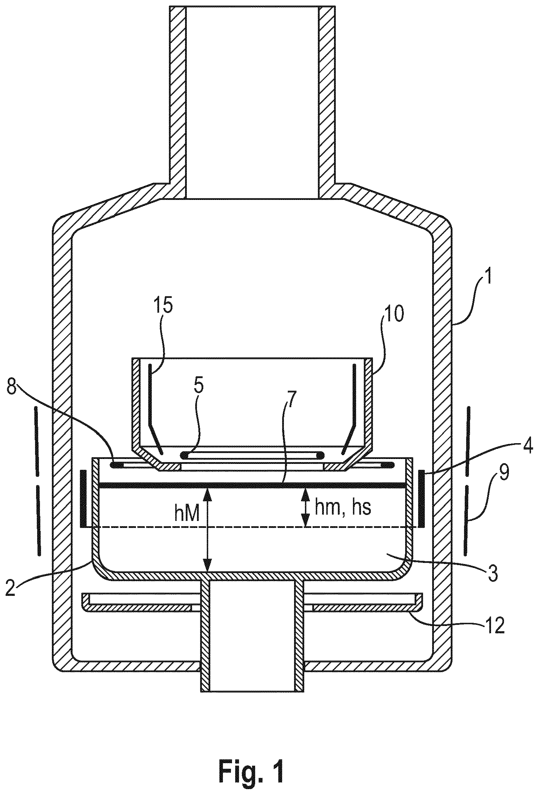

Die Vorrichtung gemäß Fig.1 umfasst ein Gehäuse 1, in dem ein Quarz-Tiegel 2 untergebracht ist. Der Quarz-Tiegel 2 kann gedreht, angehoben und abgesenkt werden. Im Quarz-Tiegel 2 befindet sich eine Schmelze 3 aus Silizium, die von oben, von der Seite und im gezeigten Anwendungsbeispiel auch von unten erhitzt wird.

Außerhalb des Gehäuses 1 ist eine Einrichtung 9 zum Beaufschlagen der Schmelze 3 mit einem Magnetfeld vorgesehen. Zum Erhitzen der Schmelze 3 von der Seite steht eine erste Heizeinrichtung 4 zur Verfügung, die um den Quarz-Tiegel 2 herum angeordnet ist. Eine zweite Heizeinrichtung 5 zum Erhitzen der Schmelze 3 von oben im Bereich einer Phasengrenze zwischen einem wachsenden Einkristall 6 und der Schmelze 3 ist in geringem Abstand zur Oberfläche 7 der Schmelze 3 angeordnet, ebenso wie eine dritte Heizeinrichtung 8, die zum Erhitzen der Schmelze von oben im Bereich der Oberfläche 7 der Schmelze 3 vorgesehen ist. Zwischen der zweiten und der dritten Heizeinrichtung befindet sich ein Hitzeschild 10, der den wachsenden Einkristall 6 umgibt, der von der Oberfläche 7 der Schmelze 3 weg nach oben gezogen wird. Der Abstand zwischen einem unteren Ende 11 des Hitzeschilds 10 und der Oberfläche 7 der Schmelze 3 bleibt während des Wachstums des Einkristalls 6 im Wesentlichen unverändert, da der Quarz-Tiegel 2 so angehoben wird, dass die Oberfläche 7 der Schmelze 3 trotz des Wachsens des Einkristalls 6 weder absinkt noch ansteigt. Konzentrisch zum Hitzeschild 10 und von diesem umgeben ist eine Kühlvorrichtung 15 angeordnet. Unter dem Quarz-Tiegel 2 befindet sich eine vierte Heizeinrichtung 12 zum Erhitzen der Schmelze von unten.

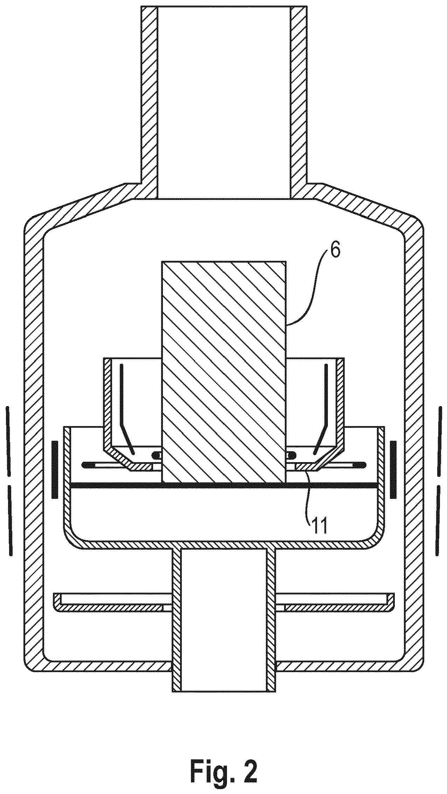

Wie in Fig.2 dargestellt, ändert sich der Abstand zwischen dem unteren Ende 11 des Hitzeschilds während des Ziehens des Einkristalls 6 im Wesentlichen nicht. Gleiches gilt nicht für den Abstand hs zwischen der unteren Begrenzung der ersten Heizeinrichtung 4 und der Oberfläche der Schmelze 7, der wegen des Anhebens des Quarz-Tiegels 2 im Verlauf des Wachsens des Einkristalls 6 abnimmt.

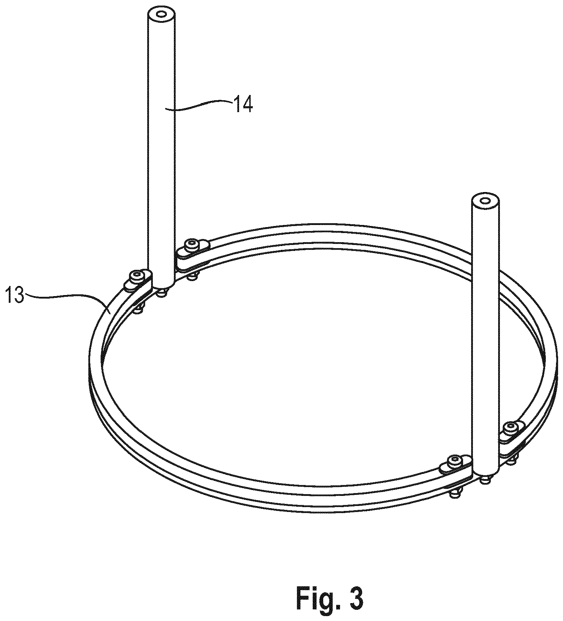

Die dritte Heizeinrichtung 8 kann ausgestaltet sein, wie es in Fig. 3 dargestellt ist. Sie umfasst im Wesentlichen einen Ring 13, der als Heizelement arbeitet und Stromzuführungen 14 zum Zuführen von elektrischem Strom in den Ring und zum Halten des Rings über der Oberfläche 7 der Schmelze.

### Liste der verwendeten Bezugszeichen

- **1**: Gehäuse
- **2**: Quarz-Tiegel
- **3**: Schmelze
- **4**: erste Heizeinrichtung
- **5**: zweite Heizeinrichtung
- **6**: Einkristall
- **7**: Oberfläche der Schmelze
- **8**: dritte Heizeinrichtung
- **9**: Einrichtung zum Beaufschlagen der Schmelze mit einem Magnetfeld
- **10**: Hitzeschild
- **11**: unteres Ende des Hitzeschilds
- **12**: vierte Heizeinrichtung
- **13**: Ring
- **14**: Stromzuführungen
- **15**: Kühlvorrichtung

### Detaillierte Beschreibung erfindungsgemäßer Ausführungsbeispiele

Einkristalle aus Silizium wurden nach der CZ-Methode in einer Vorrichtung mit erfindungsgemäßen Merkmalen gezogen und zu n-dotierten Halbleiterscheiben mit einem Durchmesser von 300 mm verarbeitet.
Die Sauerstoff-Konzentration eines großen Teils der Halbleiterscheiben war kleiner als 2,2 x 10¹⁷ Atome/cm³ (new ASTM) und der radiale Verlauf der Sauerstoff-Konzentration bis in den Randbereich sehr homogen.

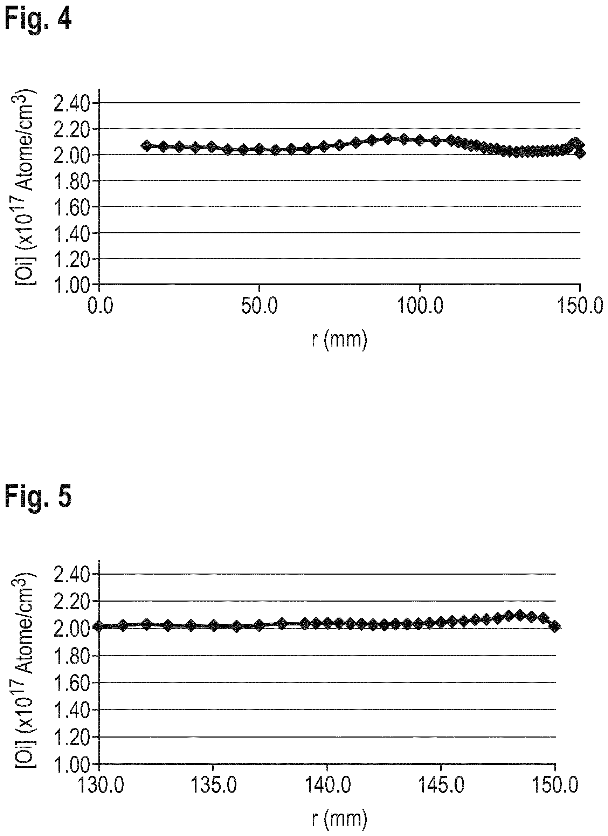

Fig.4 zeigt den typischen Verlauf der Konzentration an interstitiellem Sauerstoff [Oᵢ] solcher Halbleiterscheiben in Abhängigkeit der radialen Position r und Fig.5 mit höherer Auflösung den entsprechenden Konzentrationsverlauf in einem Randbereich umfassend die radialen Positionen 130 mm bis 150 mm.

Die Dichte an thermischen Donatoren in diesen Halbleiterscheiben war kleiner als 3 x 10¹³/cm³ und wurde mittels Widerstandsmessung bestimmt. Die Widerstandsmessung erfolgte vor und nach einer RTA-Wärmebehandlung bei 743 °C über einen Zeitraum von 10 s. Die aus der Widerstandsdifferenz errechnete Dotierstoffkonzentration entspricht der Dichte an thermischen Donatoren.

Teilweise wurde mit dem Ziehen des Abschnitts des Einkristalls mit einheitlichem Durchmesser und dem Gegendotieren gleichzeitig begonnen, teilweise wurde das Gegendotieren erst eingeleitet, nachdem 40 % der Länge des Abschnitts kristallisiert waren. Es wurde festgestellt, dass das spätere Gegendotieren einen Ausbeutezuwachs von 10 % einbrachte, wenn von den Halbleiterscheiben zu erfüllen war, dass vom Zentrum bis zum Rand der Halbleiterscheiben die Sauerstoff-Konzentration kleiner als 2,2 x 10¹⁷ Atome/cm³ ist und der spezifische Widerstand vom Mittelwert um nicht mehr als 13 % abweicht.
Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren.

## Patentansprüche

1. Verfahren zur Herstellung einer Halbleiterscheibe aus einkristallinem Silizium, die Sauerstoff und mindestens einen Dotierstoff vom n-Typ enthält, umfassend das Bereitstellen einer Schmelze aus Silizium, die Dotierstoff vom n-Typ enthält, in einem Quarz-Tiegel, wobei eine Oberfläche der Schmelze eine anfängliche Höhe hM hat;
das Erhitzen der Schmelze von der Seite durch selektives Zuführen von Wärme zu einem oberen Volumen der Schmelze, das eine anfängliche Höhe hm hat, wobei die Höhe hm kleiner ist als die Höhe hM;
das Ziehen eines Einkristalls aus Silizium gemäß der CZ-Methode aus der Schmelze mit einer Ziehgeschwindigkeit V;
das Erhitzen der Schmelze von oben im Bereich einer Phasengrenze zwischen dem wachsenden Einkristall und der Schmelze;
das Erhitzen der Schmelze von oben im Bereich der Oberfläche der Schmelze zwischen einem Hitzeschild und einer Wand des Quarz-Tiegels;
das Beaufschlagen der Schmelze mit einem Magnetfeld;
das Gegendotieren der Schmelze mit Dotierstoff vom p-Typ; und
das Abtrennen der Halbleiterscheibe aus einkristallinem Silizium vom Einkristall.

2. Verfahren nach Anspruch 1, zusätzlich umfassend das Erhitzen der Schmelze von unten mit einer ersten Heizleistung, die im Verhältnis zu einer zweiten Heizleistung, mit der die Schmelze von der Seite erhitzt wird, nicht mehr als 5 % beträgt.

3. Verfahren nach Anspruch 1 oder Anspruch 2, umfassend das Erhitzen der Schmelze von oben im Bereich der Phasengrenze mit einer dritten Heizleistung, die im Verhältnis zu einer Gesamtheizleistung nicht weniger als 5 % und nicht mehr als 15 % beträgt.

4. Verfahren nach einem der Ansprüche 1 bis 3, umfassend das Erhitzen der Schmelze von oben im Bereich der Oberfläche der Schmelze mit einer vierten Heizleistung, die im Verhältnis zur Gesamtheizleistung nicht weniger als 5 % und nicht mehr als 15 % beträgt.

5. Verfahren nach einem der Ansprüche 1 bis 4, **dadurch gekennzeichnet, dass** beim Gegendotieren ein Gas, das einen Dotierstoff vom p-Typ enthält, in einem Abstand von 5 bis 50 mm zur Oberfläche der Schmelze in eine Atmosphäre über der Schmelze eingeleitet wird.

6. Verfahren nach einem der Ansprüche 1 bis 5, zusätzlich umfassend das Ziehen von mindestens 20 % eines Abschnitts des Einkristalls, der einen einheitlichen Durchmesser hat, bevor mit dem Gegendotieren begonnen wird.

7. Verfahren nach einem der Ansprüche 1 bis 6, umfassend das Kontrollieren der Ziehgeschwindigkeit V derart, dass Silizium-Zwischengitteratome im wachsenden Einkristall keine Agglomerate bilden und die Konzentration an freien Leerstellen nicht mehr als 3 x 10¹⁴/cm³ beträgt.

8. Verfahren nach einem der Ansprüche 1 bis 7, zusätzlich umfassend das Abkühlen des wachsenden Einkristalls aus Silizium im Temperaturbereich von 500 °C bis 400 °C mit einer Abkühlrate von nicht weniger als 0,15 °C/min und nicht mehr als 0,6 °C/min.

9. Verfahren nach einem der Ansprüche 1 bis 8, umfassend das Beaufschlagen der Schmelze mit einem Magnetfeld vom CUSP-Typ.

10. Vorrichtung zur Herstellung einer Halbleiterscheibe aus einkristallinem Silizium gemäß der CZ-Methode, umfassend
einen Quarz-Tiegel;
eine Schmelze aus Silizium im Quarz-Tiegelmit einer Oberfläche, die eine anfängliche Höhe hM hat;
eine Einrichtung zum Beaufschlagen der Schmelze mit einem Magnetfeld;
einen Hitzeschild zum Abschirmen eines wachsenden Einkristalls aus Silizium;
eine erste Heizeinrichtung zum Erhitzen der Schmelze von der Seite mit einer unteren Begrenzung, die tiefer angeordnet ist, als die Oberfläche der Schmelze mit anfänglicher Höhe hM, wobei der Abstand hs der unteren Begrenzung zur Oberfläche der Schmelze mit anfänglicher Höhe hM kleiner ist, als die anfängliche Höhe hM; eine zweite Heizeinrichtung zum Erhitzen der Schmelze von oben im Bereich einer Phasengrenze zwischen dem wachsenden Einkristall und der Schmelze; und
eine dritte Heizeinrichtung zum Erhitzen der Schmelze von oben, die um den Hitzeschild herum zwischen einer Wand des Quarz-Tiegels und dem Hitzeschild angeordnet ist.

11. Vorrichtung nach Anspruch 10, wobei die dritte Heizeinrichtung einen Ring umfasst, dessen Querschnitt ein Aspekt-Verhältnis von Höhe zu Breite hat, das nicht mehr als 0,35 beträgt.

12. Vorrichtung nach Anspruch 10 oder Anspruch 11, **dadurch gekennzeichnet, dass** die Einrichtung zum Beaufschlagen der Schmelze mit einem Magnetfeld ein Magnetfeld vom CUSP-Typ erzeugt.

13. Vorrichtung nach einem der Ansprüche 10 bis 12, zusätzlich umfassend eine Abdeckung, die über der dritten Heizeinrichtung angeordnet ist und die dritte Heizeinrichtung nach oben hin thermisch isoliert.

14. Vorrichtung nach einem der Ansprüche 10 bis 13, zusätzlich umfassend eine vierte Heizeinrichtung zum Erhitzen des Quarz-Tiegels von unten.

15. Vorrichtung nach einem der Ansprüche 10 bis 14, zusätzlich umfassend eine Kühlvorrichtung, die den wachsenden Einkristall umgibt.

## Claims

1. Method for producing a semiconductor wafer of monocrystalline silicon containing oxygen and at least one n-type dopant, comprising providing a melt of silicon containing n-type dopant in a quartz crucible, wherein a surface of the melt has an initial height hM; heating the melt from the side by selectively supplying heat to an upper volume of the melt having an initial height hm, the height hm being less than the height hM; pulling a single crystal of silicon according to the CZ method from the melt at a pulling speed V; heating of the melt from above in the area of a phase boundary between the growing single crystal and the melt the heating of the melt from above in the area of the melt surface between a heat shield and a wall of the quartz crucible; the application of a magnetic field to the melt; counter-doping the melt with p-type dopant; and the separation of the semiconductor wafer of single-crystal silicon from the single crystal.

2. The method according to claim 1, additionally comprising heating the melt from below with a first heating power which is not more than 5% relative to a second heating power with which the melt is heated from the side.

3. The method according to claim 1 or claim 2, comprising heating the melt from above in the region of the phase boundary with a third heating power which is not less than 5% and not more than 15% in relation to a total heating power.

4. A method according to any one of claims 1 to 3 comprising heating the melt from above in the region of the surface of the melt with a fourth heating power which is not less than 5% and not more than 15% relative to the total heating power.

5. Method according to one of claims 1 to 4, **characterized in that**, during counterdoping, a gas containing a p-type dopant is introduced into an atmosphere above the melt at a distance of 5 to 50 mm from the surface of the melt.

6. A method according to any one of claims 1 to 5, additionally comprising pulling at least 20% of a portion of the single crystal having a uniform diameter before counter-doping is started.

7. A method according to any one of claims 1 to 6, comprising controlling the pulling speed V such that silicon interstitial atoms in the growing single crystal do not form agglomerates and the concentration of free vacancies is not more than 3 x¹⁰¹⁴/cm3.

8. A method according to any one of claims 1 to 7, additionally comprising cooling the growing single crystal of silicon in the temperature range of 500°C to 400°C at a cooling rate of not less than 0.15°C/min and not more than 0.6°C/min.

9. A method according to any one of claims 1 to 8, comprising applying a CUSP-type magnetic field to the melt

10. Device for producing a semiconductor wafer of single crystal silicon according to the CZ method, comprising a quartz crucible;
a melt of silicon in a quartz crucible with a surface having an initial height hM;
a device for applying a magnetic field to the melt;
a heat shield for shielding a growing single crystal of silicon
a first heating device for heating the melt from the side with a lower boundary which is arranged lower than the surface of the melt with initial height hM, the distance hs of the lower boundary to the surface of the melt with initial height hM being smaller than the initial height hM;
a second heating device for heating the melt from above in the region of a phase boundary between the growing single crystal and the melt; and
a third heating device for heating the melt from above, which is arranged around the heat shield between a wall of the quartz crucible and the heat shield

11. The device according to claim 10, wherein the third heater comprises a ring whose cross-section has an aspect ratio of height to width not exceeding 0.35.

12. Device according to claim 10 or claim 11, **characterized in that** the device for applying a magnetic field to the melt generates a magnetic field of the CUSP type.

13. Device according to any one of claims 10 to 12, additionally comprising a cover which is arranged above the third heating device and thermally insulates the third heating device towards the top.

14. Device according to any one of claims 10 to 13, additionally comprising a fourth heating device for heating the quartz crucible from below.

15. Device according to any of claims 10 to 14, additionally comprising a cooling device surrounding the growing single crystal

## Revendications

1. Méthode de fabrication d'une plaquette semi-conductrice en silicium monocristallin contenant de l'oxygène et au moins un dopant de type n, comprenant fournir une masse fondue de silicium contenant un dopant de type n dans un creuset en quartz, dans lequel une surface de la masse fondue a une hauteur initiale hM ;
le chauffage de la masse fondue par le côté en fournissant sélectivement de la chaleur à un volume supérieur de la masse fondue ayant une hauteur initiale hm, la hauteur hm étant inférieure à la hauteur hM ;
le tirage d'un monocristal de silicium selon la méthode CZ à partir de la masse fondue à une vitesse de tirage V ;
le chauffage de la masse fondue par le haut dans la zone d'une limite de phase entre le monocristal en croissance et la masse fondue
le chauffage de la fonte par le haut dans la zone de la surface de la fonte entre un bouclier thermique et une paroi du creuset en quartz ;
l'application d'un champ magnétique à la masse fondue ;
contre-dopage de la fonte avec un dopant de type p
la séparation de la plaquette semi-conductrice de silicium monocristallin du monocristal.

2. La méthode selon la revendication 1, comprenant en outre le chauffage de la masse fondue par le bas avec une première puissance de chauffage qui n'est pas supérieure à 5 % par rapport à une deuxième puissance de chauffage avec laquelle la masse fondue est chauffée par le côté.

3. La méthode selon la revendication 1 ou la revendication 2, comprenant le chauffage de la masse fondue par le haut dans la région de la limite de phase avec une troisième puissance de chauffage qui n'est pas inférieure à 5 % et pas supérieure à 15 % par rapport à une puissance de chauffage totale.

4. La méthode selon l'une quelconque des revendications 1 à 3, consistant à chauffer la masse fondue par le haut dans la région de la surface de la masse fondue avec une quatrième puissance de chauffage qui n'est pas inférieure à 5 % et pas supérieure à 15 % par rapport à la puissance de chauffage totale.

5. Méthode selon l'une des revendications 1 à 4, **caractérisé en ce que**, lors du contre-dopage, un gaz contenant un dopant de type p est introduit dans une atmosphère au-dessus de la masse fondue à une distance de 5 à 50 mm de la surface de la masse fondue.

6. Une méthode selon l'une des revendications 1 à 5, comprenant en outre le tirage d'au moins 20 % d'une partie du monocristal ayant un diamètre uniforme avant le début du contre-dopage.

7. Une méthode selon l'une quelconque des revendications 1 à 6, comprenant le contrôle de la vitesse de tirage V de telle sorte que les atomes interstitiels de silicium dans le monocristal en croissance ne forment pas d'agglomérats et que la concentration de postes libres ne soit pas supérieure à 3 x¹⁰¹⁴/cm3.

8. Une méthode selon l'une quelconque des revendications 1 à 7, comprenant en outre le refroidissement du monocristal de silicium en croissance dans la plage de température de 500°C à 400°C à une vitesse de refroidissement non inférieure à 0,15°C/min et non supérieure à 0,6°C/min.

9. Une méthode selon l'une quelconque des revendications 1 à 8, comprenant l'application d'un champ magnétique de type CUSP à la masse fondue

10. Dispositif pour la production d'une plaquette semi-conductrice de silicium monocristallin selon la méthode CZ, comprenant
un creuset en quartz ;
une fusion de silicium dans un creuset de quartz dont la surface a une hauteur initiale hM ;
un dispositif permettant d'appliquer un champ magnétique à la masse fondue ;
un bouclier thermique pour protéger un monocristal de silicium en croissance un premier dispositif de chauffage pour chauffer la masse fondue par le côté dont la limite inférieure est disposée plus bas que la surface de la masse fondue de hauteur initiale hM, la distance hs de la limite inférieure à la surface de la masse fondue de hauteur initiale hM étant inférieure à la hauteur initiale hM ;
un deuxième dispositif de chauffage pour chauffer la masse fondue par le haut dans la région d'une limite de phase entre le monocristal en croissance et la masse fondue ; et
un troisième dispositif de chauffage pour chauffer la masse fondue par le haut, qui est disposé autour de l'écran thermique entre une paroi du creuset en quartz et l'écran thermique

11. Le dispositif selon la revendication 10, dans lequel le troisième élément chauffant comprend un anneau dont la section transversale a un rapport d'aspect de la hauteur à la largeur ne dépassant pas 0,35.

12. Le dispositif selon la revendication 10 ou la revendication 11, **caractérisé en ce que** le dispositif pour appliquer un champ magnétique à la masse fondue génère un champ magnétique du type CUSP.

13. Dispositif selon l'une des revendications 10 à 12, comprenant en outre un couvercle qui est disposé au-dessus du troisième dispositif de chauffage et qui isole thermiquement le troisième dispositif de chauffage vers le haut.

14. Dispositif selon l'une des revendications 10 à 13, comprenant en outre un quatrième dispositif de chauffage pour chauffer le creuset en quartz par le bas

15. Dispositif selon l'une des revendications 10 à 14, comprenant en outre un dispositif de refroidissement entourant le monocristal en cours de croissance
